Europäisches Patentamt

European Patent Office

Office européen des brevets

(11) Veröffentlichungsnummer: **0 321 798 B1**

# EUROPÄISCHE PATENTSCHRIFT

(45) Veröffentlichungstag der Patentschrift: **09.03.94**

(21) Anmeldenummer: **88120573.6**

(22) Anmeldetag: **09.12.88**

(51) Int. Cl.5: **H03K 17/30**, H03K 17/16,
H03K 17/725

(54) **Schaltungsanordnung zur Steuerung eines Leistungstriacs.**

(30) Priorität: **22.12.87 DE 3743556**

(43) Veröffentlichungstag der Anmeldung:
**28.06.89 Patentblatt 89/26**

(45) Bekanntmachung des Hinweises auf die
Patenterteilung:
**09.03.94 Patentblatt 94/10**

(84) Benannte Vertragsstaaten:
**AT BE CH DE ES FR GB IT LI NL SE**

(56) Entgegenhaltungen:
**EP-A- 0 244 743
DE-A- 2 942 662
FR-A- 2 448 805
US-A- 3 940 634
US-A- 4 158 150**

(73) Patentinhaber: **Asea Brown Boveri Aktiengesellschaft
Kallstadter Strasse 1
D-68309 Mannheim(DE)**

(72) Erfinder: **Blomberg, Lothar
Tannenweg 57
D-5982 Neuenrade(DE)**

(74) Vertreter: **Rupprecht, Klaus, Dipl.-Ing. et al
c/o ABB Patent GmbH,
Postfach 10 03 51
D-68128 Mannheim (DE)**

**Beschreibung**

Schaltungsanordnung zur Steuerung eines Leistungstriacs, der in Reihe zu einer vom Netz gespeisten Last liegt und diese in Abhängigkeit von der Schaltstellung eines Steuerschalters an Spannung legt, wobei der Steuerschalter über eine Ansteuerschaltung so auf das Gate des Leistungstriacs wirkt, daß vor jedem Durchschalten seiner Schaltstrecke ein Restphasenanschnitt verbleibt und hierzu ein RC-Glied mit einem Zündkondensator den Zündstrom für den Leistungstriac über eine Triggerdiode an das Gate des Leistungstriacs liefert.

In zunehmendem Maße verwendet man in Lichtstromkreisen, die zuvor mittels mechanischer Steuer- und Schalteinrichtungen realisiert wurden, elektronische Schalter, da diese eine Automatisierung erleichtern.

So ist aus der EP-A1-0 098 521 ein Verfahren und eine Vorrichtung zum automatischen Schalten einer Raumbeleuchtung bekannt geworden, bei der in Abhängigkeit von der Anwesenheit einer Person die Raumbeleuchtung automatisch eingeschaltet und in ihrer Helligkeit auf die vorhandene Raumbeleuchtung abgestimmt wird. Hierzu dient ein in der Vorrichtung angeordneter Infrarot-Detektor, der die Körperstrahlung einer im Raum befindlichen Person aufnimmt und das Steuersignal eines zusätzlich angeordneten lichtempfindlichen Elementes berücksichtigt.

Dabei ist die elektronische Schaltung eines solchen Schaltgerätes derart konzipiert, daß ein, beispielsweise vom Sensor ausgehendes, Schaltsignal in Form eines Spannungsimpulses, von einer Auswerteelektronik in ein statisches Ausgangssignal mit einstellbarer Zeitdauer umgewandelt wird und so zur Ansteuerung eines LeistungsSchaltelementes, insbesondere Leistungstriacs, dient.

Darüberhinaus ist es aber auch bekannt, elektronische Schalter unter Benutzung eines Leistungstriacs zur Ein-und Ausschaltung eines Lichtstromkreises vorzusehen, die beispielsweise von einem Sensor - ähnlich dem aus der EP-A1 0 098 521 bekannten - angesteuert werden.

Die elektronische Schaltung solcher Schalter arbeitet - in vereinfachter Darstellung - derart, daß der vom Sensor ausgehende Spannungsimpuls durch elektronische Verarbeitung, beispielsweise mit Verstärker, Komparator und Monoflop, in ein statisches Ausgangssignal mit einstellbarer Zeitdauer umgewandelt wird.

Dieses Ausgangssignal steuert einen elektronischen Schalter, der Zündimpulse für einen Leistungstriac freigibt.

Zum Betreiben sowohl des elektronischen Sensors und auch der elektronischen Verarbeitungsschaltung ist eine ausreichende Stromversorgung erforderlich. Diese wird bei Benutzung des zu schaltenden Netzes dadurch erreicht, daß der als Schalter eingesetzte Leistungstriac nicht die volle Phase durchschaltet, sondern einen Restphasenanschnitt bewirkt, der zur Versorgung der Steuerelektronik dient.

Der im eingeschalteten Zustand des Leistungstriacs erforderliche Restphasenanschnitt ist vom Strombedarf der Steuerschaltung abhängig, muß also um so größer gewählt werden, je größer der Strombedarf der Elektronik ist. Mit einem großen Restphasenanschnitt erhöht sich aber der Aufwand für die Funkentstörung des elektronischen Schalters, was mit entsprechenden Kosten verbunden ist.

Eine Schaltung, die einen Restphasenanschnitt ermöglicht, baut man in bekannter Weise so auf, daß zur Steuerung eines Leistungstriacs, der in Reihe zu einer vom Netz gespeisten Last liegt, eine Ansteuerschaltung dient. Ein mit einem elektronischen Sensor versehener Steuerschalter wirkt hierbei über die Ansteuerschaltung so auf das Gate des Leistungstriacs, daß vor jedem Durchschalten seiner Schaltstrecke eine Verzögerung erfolgt, die zum Phasenanschnitt fuhrt. Die Zeitkonstante der Verzögerung bestimmt ein RC-Glied, dessen Zündkondensator den Zundstrom für den Leistungstriac über eine Triggerdiode liefert. Soll der Leistungstriac nicht durchgeschaltet werden, also z. B. eine Lampe ausgeschaltet bleiben, so schließt die Schaltstrecke eines parallel zum Zündkondensator liegenden Hilfstriacs diesen kurz. Das Gate des Triacs wird hierzu mit einem entsprechenden Signal des Steuerschalters beaufschlagt.

Die Größe des Restphasenanschnittes wird durch die Dimensionierung des Widerstandes, des Kondensators und der Triggerdiode festgelegt. Der Minimierung des Restphasenanschnittes sind dabei deutliche Grenzen gesetzt. Um eine kleine Zeitkonstante zu erreichen müßte der Widerstand auf einen relativ kleinen Wert festgelegt werden. Dies hätte jedoch zur Folge, daß im nicht durchgeschalteten Zustand der Widerstand an voller Netzspannung liegen würde und eine entsprechend hohe Verlustleistung entstünde. Aber auch der Zündkondensator darf einen bestimmten Mindestwert nicht unterschreiten, da sonst die Zündimpulse nicht mehr ausreichen würden. Ein weiterer Nachteil dieser Schaltung liegt darin, daß der Hilfstriac mit einem relativ hohen Strom von mehreren Milliampere angesteuert werden muß.

Aus der US-A-4 158 150 ist eine Schaltungsanordnung zur Steuerung eines in Reihe zu einer Last liegenden Triacs bekannt. Der Triac wird über eine Gleichrichterbrückenschaltung mit Hilfe einer Ansteuerschaltung nach entsprechender Ansteuerung in den leitenden Zustand versetzt. Dieses Einschalten soll möglichst unmittelbar nach dem Nulldurchgang der Netzwechselspannung erfolgen Eine Diode kann im Diagonalzweig der Brückenschaltung eingefügt werden. Maßnahmen zur Reduzierung des Stromverbrauchs der Ansteuerschaltung und einer hierdurch erreichbaren Verkleinerung des Restphasenanschnittes werden nicht beschrieben.

Weiterhin ist in der FR-A-2 448 805 eine aus einem RC-Glied und einer Triggerdiode bestehende Schaltung beschrieben, die jedoch keine mit einer Brückenschaltung in Verbindung stehende Ansteuerschaltung enthält.

Weiterhin ist aus der EP-A-0 244 743 noch ein Zweidrahtschalter bekannt, der zum Anschalten einer Last an einer Wechselspannungsquelle dient, bei der auch eine Brückenschaltung eingesetzt wird, deren Aufgabe sich darauf beschränkt, die für eine Hilfsspannung benötigte Gleichspannung zu erzeugen.

Aus der DE-OS 29 42 662 ist weiterhin bekannt, eine sternerbare Gleichrichter-Brückenschaltung zur Aufladung eines Zündkondensators nicht aber zu seiner Entladung zu verwenden. Der Schaltung liegt auch eine völlig andere Aufgabe zugrunde, weil kein Restphasenanschnitt erzeugt werden soll, sondern gedimmt wird. Bezüglich der Anwendung wurde an eine Treppenharnsbeleuchtung gedacht, die nicht mehr abrupt abgeschaltet werden, sondern langsam innerhalb einer vorgegebenen Zeit verlöschen soll.

Schließlich ist aus dem Patent US-A-3 940 634 eine Schaltungsanordnung zur Steuerung eines Leistungstriacs bekannt, mit einer Gleichrichter - Brückenschaltung, in deren Diagonalzweig ein steuerbarer Transistor liegt. Eine Versorgungsschaltung ist vorgesehen, die parallel zum Leistungstriac geschaltet ist und den zur Ansteuerung des Transistors notwendigen Steuerstrom abgibt.

Ausgehend von dem vorstehend beschriebenen Stand der Technik ist es daher Aufgabe der Erfindung, eine Schaltungsanordnung der eingangs genannten Art anzugeben, welche mit einem möglichst kleinen Restphasenanschnitt auskommt, damit die Funkentstörung einen möglichst geringen Aufwand erfordert.

Diese Aufgabe wird durch die im Anspruch 1 definierten Merkmale gelöst. Zweckmäßige Ausgestaltungen und Weiterbildungen der Erfindung sind in den abhängigen Ansprüchen genannt.

Von wesentlicher Bedeutung ist, daß mit der erfindungsgemäßen Schaltung der Zundkondensator während der Sperrzeit des Leistungstriacs nicht mehr über den gezündeten Hilfs-Triac kurzgeschlossen wird und sich dadurch die am Vorwiderstand des Zündkondensators entstehende Verlustleistung entscheidend vermindert. Die Steuerschaltung läßt sich dadurch so dimensionieren, daß sie mit einem wesentlich geringeren Strom auskommt und somit auch der Restphasenanschnitt (Zündwinkel oder Zündverzögerungswinkel) verkürzt werden kann. Hierdurch vermindern sich die Störspannungen, so daß auch der Aufwand zur Entstörung herabgesetzt werden kann.

Eine sehr vorteilhafte Weiterbildung der Erfindung wird mit Hilfe einer Treiberschaltung erreicht, da diese den vom Steuerschalter aufzubringenden Steuerstrom entscheidend verringert. Für den Aufbau der Gesamtschaltung ist besonders wichtig, daß die Treiberschaltung sowohl in der positiven wie auch in der negativen Halbwelle der Wechselspannung eine Ansteuerung des steuerbaren Halbleiterschalters im Diagonalzweig der Halbleiterbrücke ermöglicht. Das ist mit erheblichen Schwierigkeiten verbunden, weil der Polaritätswechsel völlig unterschiedliche Stromwege erfordert.

Damit der von der Treiberschaltung kommende Steuerstrom für den steuerbaren Halbleiterschalter auf dem kürzesten Weg mit den geringsten Verlusten abfließen kann, muß die Triggerdiode zwischen den Zündkondensator und den steuerbaren Halbleiterschalter eingefügt werden.

Im Prinzip kann der steuerbare Halbleiterschalter durch einen Triac, einen Transistor oder auch einen Thyristor gebildet werden. Ein Thyristor hat gegenüber einem Triac den Vorteil, daß er mit einem geringeren Steuerstrom auskommt, was sich wiederum günstig auf die Verminderung des Restphasenanschnittes auswirkt.

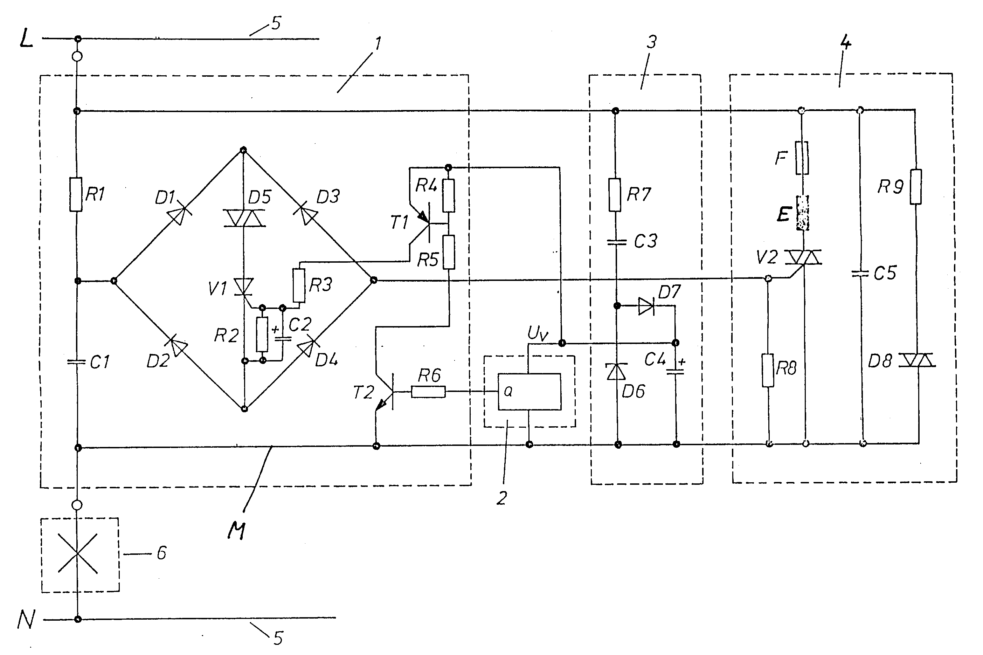

Im folgenden werden anhand des in der Zeichnung dargestellten Ausführungsbeispieles die Erfindung und vorteilhafte Ausgestaltungen näher erläutert und beschrieben.

Der Wirkschaltplan ist in verschiedene Baugruppen unterteilt. Eine Ansteuerschaltung 1 wird durch einen elektronischen Steuerschalter 2 entsprechend dessen Schaltstellung mit einem Steuersignal beaufschlagt, und gibt in Abhängigkeit hiervon ein eigenes Steuersignal an einen Leistungsschaltteil 4 weiter. Der Leistungsschaltteil 4 verbindet eine Last 6, die am Nulleiter N eines Netzes 5 liegt, mit dem Phasenleiter L dieses Netzes. Eine Stromversorgungsschaltung 3 erzeugt die vom Steuerschalter 2 und von der Ansteuerschaltung 1 benötigte Versorgungsspannung.

Die Verbindung zwischen dem Leistungsschaltteil 4 und der Last 6 bildet ein für alle Baugruppen 1, 2, 3, 4, 6 gemeinsames Bezugspotential M. Auf Bezugspotential M liegt auch ein Zündkondensator C1, der über einen Vorwiderstand R1 mit dem Phasenleiter L verbunden ist. Eine aus vier Dioden D1, D2, D3, D4 gebildete Gleichrichter-Brückenschaltung liegt mit ihrem einen Wechselspannungseingang, der durch die Dioden D1, D2 gebildet ist zwischen dem Zündkondensator C1 und dem Vorwiderstand R1. Der von den Dioden D3, D4 gebildete andere Wechselspannungseingang liegt am Steuereingang des Leistungsschaltteils 4. An dem durch die beiden Dioden D1, D3 gebildeten positiven Ausgang des Brückengleichrichters liegt eine Triggerdiode D5. Mit dieser in Reihe geschaltet ist die Schaltstrecke eines Thyristors V1, der mit seiner Kathode an dem durch die beiden Dioden D2, D4 gebildeten negativen Ausgang des Brückengleichrichters angeschlossen ist.

Es kann aber die Triggerdiode D5 auch zwischen den Zündkondensator C1 und den durch D1 und D2 gebildeten Wechselspannungsanschluß angeordnet werden.

Zur Ansteuerschaltung 1 gehört neben dem Brückengleichrichter noch eine aus zwei komplementären Transistorstufen bestehende Treiberschaltung. Der Kollektor eines pnp-Transistors T1 ist über einen Widerstand R3 mit dem Gate des Thyristors V1 verbunden, während er mit seinem Emitter am Ausgang der Stromversorgungsschaltung 3 liegt, die eine Ausgangsspannung $U_V$ abgibt. Ein npn-Transistor T2 ist über seinen Emitter mit Bezugspotential M verbunden, wahrend sein Kollektor über einen Widerstand R5 an der Basis des pnp-Transistors T2 liegt. Die Basis ist ihrerseits über einen Widerstand R4 am Ausgang $U_V$ der Stromversorgungsschaltung 3 angeschlossen, und der Ausgang des Steuerschalters 2 ist über einen Widerstand R6 der Basis des npn-Transistors T2 zugeführt.

Der Steuerschalter 2 ist ein elektronischer Schalter, der z. B. als Bewegungsmelder mit einem Infrarot-Detektor ausgerüstet ist und bei Erfassung der von einem Strahlungsobjekt ausgehenden Wärmestrahlung ein Steuersignal an die Ansteuerschaltung 1 abgibt. Ebenso wie diese wird er durch die Stromversorgungsschaltung 3 mit der Spannung $U_V$ gespeist.

Die Stromversorgungsschaltung 3 ist über einen Widerstand R7 mit dem Phasenleiter L des Netzes und mit der Anode einer Zenerdiode D6 mit dem Bezugspotential M verbunden. Zwischen diesen beiden Bauteilen liegt mit ihnen in Reihe ein Ladekondensator C3, und parallel zur Zenerdiode D6 die Reihenschaltung einer Diode D7 und eines Kondensators C4, der mit Bezugspotential M verbunden ist. Zenerdiode D6 und Diode D7 sind so gepolt, daß sich der Pufferkondensator C4 wahrend der positiven Halbwelle der Wechselspannung auf eine positive Spannung $U_V$ auflädt, die etwa der Zenerspannung entspricht.

Der Steuereingang des Leistungsschaltteils 4 ist mit dem Gate eines Thyristors V2 identisch, das über einen Widerstand R8 mit Bezugspotential M verbunden ist. Die ebenfalls einseitig an Nullpotential angeschlossene Strecke des Leistungsthyristors V2 liegt zum Phasenleiter L hin in Reihe mit einer Entstördrossel E und einer Sicherung F. Parallel zu dieser Reihenschaltung, also ebenfalls zwischen Phasenleiter L und Bezugspotential M, ist ein Entstörkondensator C5 eingesetzt, zu dem wiederum eine Reihenschaltung aus einem Widerstand R9 und einer Suppressordiode D8 parallel geschaltet ist.

Im folgenden soll nun im wesentlichen auf die Funktionsweise der erfindungsgemäßen Schaltungsanordnung eingegangen werden.

Im nichtaktiven Zustand des Steuerschalters 2 steht an seinem Q-Ausgang der Spannungswert 0 an.

Damit werden in der Ansteuerschaltung 1 die Transistoren T2 und T1 gesperrt. Folglich erhält der Thyristor V1 keinen Gatestrom. Es kann also vom Netz her kein Zündstrom über den Brückenzweig D5, V1 in das Gate des Leistungstriacs V2 fließen, womit dieser gesperrt bleibt.

R2 bildet den am Gate des Thyristors V1 notwendigen Abschlußwiderstand. Der Kondensator C2 schließt vom Netz eingekoppelte Spannungsspitzen kurz und verhindert unerwünschte Zündungen.

Eine weitere Unterdrückung von Spannungsspitzen erfolgt durch den Widerstand R9 und die Diode D8 im Leistungsschalter 4.

Im aktivierten Zustand steht am Q-Ausgang des Steuerschalters 2 eine Spannung an. Damit werden T2 und T1 leitend.

Im Hinblick auf die angelegte Wechselspannung soll zunächst das Verhalten bei positiver Netzhalbwelle erörtert werden.

In den Thyristor V1 fließt der notwendige Gatestrom (z. B. ca. 200 µA), womit dieser leitend wird. Der Gatestrom wird dabei der Versorgungsschaltung 3 entnommen. Er findet, seinen Weg aus der Brücke über D4 und R8 zum Bezugspotential M.

Der für den Triac V2 erforderliche Zündstrom fließt aber erst dann über den Thyristor V1, wenn die Netzspannung die Durchbruchspannung der Triggerdiode D5 (hier z. B. 36 V) sowie der Diodenstrecken erreicht hat.

Der Zündstrom wird dann von dem Kondensator C1, der bis zur Durchbruchspannung der Triggerdiode D5 aufgeladen worden ist, über D1, D5, V1, D4 an das Gate des Leistungstriacs V2 abgegeben (ca. 100 mA). Damit wird dieser sicher gezündet und bleibt während der positiven Halbwelle leitend.

Nun interessiert der Funktionsablauf bei negativer Netzhalbwelle.

Zu Beginn der negativen Netzhalbwelle, also im Nulldurchgang schaltet der Leistungstriac V2 ab. Bevor er nun seinen negativen Zündstrom erhält, stellt sich folgender Verlauf dar:

Die Versorgungsspannung $U_V$ versucht über T1, R3 einen Strom in das Gate des Thyristors V1 fließen zu lassen. Dies gelingt tatsächlich, da dieser Strom anschließend die Brücke über D2 und R1 zum Phasenleiter L hin, der ja nun negatives Potential besitzt, wieder verlassen kann. D. h., daß sich am Thyristor V1 ein Gatestrom einstellt, der kontinuierlich ansteigt, solange die Durchbruchspannung der Triggerdiode D5 noch nicht erreicht ist. Vor Erreichen dieses Punktes ergibt sich ein resultierender Gatestrom (ca. 1 mA) nach folgender Näherungs-Gleichung

$$I_{G(Thy)} \approx \frac{U_V + U_{D5}}{R_3} \; , \; z.B. \; \frac{12V + 36V}{47k\Omega} \approx 1 \; mA$$

Im Unterschied zur positiven Halbwelle, wo ein vergleichsweise niedriger Gatestrom (ca. 200 $\mu$A) fließt, stellt sich hier ein höherer Strom (ca. 1 mA) ein. Dies wirkt sich aber nicht nachteilig aus.

Bei Erreichen der Triggerspannung, d.h. der Durchbruchspannung der Triggerdiode D5 erhält der Leistungstriac V2 von C1 über D3, D5, V1 und D2 seinen Zündimpuls. Der Leistungstriac V2 bleibt während der negativen Halbwelle leitend.

Wird die Triggerdiode D5 zwischen dem Zündkondensator C1 und dem von D1 und D2 gebildeten Wechselspannungsanschluß angeordnet, dann fließt der Gatestrom (von V1) während der positiven und negativen Halbwelle stets in gleicher Höhe (z. B. 200 $\mu$A) über R3, V1 und R8, wodurch eine Unsymmetrie weitgehend vermieden wird. Dieser Strom ruft dann am Widerstand R8 einen Spannungsabfall (ca. 50 mV) hervor, wodurch eine vorzeitige Zündung des Leistungstriacs V2 unmöglich ist.

Nun folgen einige Anmerkungen zu Besonderheiten der Schaltung.

Der Widerstand R1 könnte auch den Wert Null erhalten (100 % Symmetrie). Jedoch ist ein bestimmter Widerstandswert (hier z. B. 10 k$\Omega$ ) sinnvoll, um ein unerwünschtes Durchschalten des Bruckenzweiges D5, V1 infolge von Hochspannungsspitzen zu verhindern.

Die Kombination R1 - C1 liegt an Netzspannung. Dabei wird der Kondensator C1 abwechselnd positiv und negativ über den Widerstand R1 bis zum Erreichen der Triggerspannung an der Triggerdiode D5 aufgeladen.

Während der negativen Netzhalbwelle addieren sich der gemäß Schaltplan durch C1 und der von der Spannungsversorgung her über T1, R3, V1 und D2 fließende Strom. Die Addition der beiden Ströme führt zu einer geringen Unsymmetrie des positiven und negativen Phasenanschnittes (hier 40 V/0,6 ms zu 50 V/0,7 ms). Die Unsymmetrie nimmt mit dem Widerstandsverhältnis $\frac{R1}{R3}$ zu.

Dies gilt allerdings nur, wenn sich die Triggerdiode D5, wie im Schaltbild eingetragen, im Diagonalzweig der Gleichrichter-Brückenschaltung befindet.

Es ist deshalb von Vorteil, wenn die Triggerdiode D5 unmittelbar vor dem ersten Wechselspannungseingang der Gleichrichterbrücke D1 - D4 eingefügt wird. In diesem Fall fließt der Gatestrom des Thyristors V1 während der positiven und negativen Halbwelle in gleicher Höhe von z. B. 200$\mu$A über R3, V1, D4 und R8. Hierdurch wird die Unsymmetrie weitgehend vermieden. Dieser Strom ruft an R8 einen Spannungsabfall von ca. 50mV hervor; ein vorzeitiges Zünden des Leistungstriacs V2 ist damit nicht möglich.

**Patentansprüche**

1.  Schaltungsanordnung zur Steuerung eines Leistungstriacs (V2), der in Reihe zu einer vom Netz gespeisten Last (6) liegt und diese in Abhängigkeit von der Schaltstellung eines Steuerschalters (2) an Spannung legt, wobei der Steuerschalter (2) über eine Ansteuerschaltung (1) so auf das Gate des Leistungstriacs (V2) wirkt, daß vor jedem Durchschalten seiner Schaltstrecke ein Restphasenanschnitt verbleibt und hierzu ein RC-Glied (R1, C1) mit einem Zündkondensator (C1) den Zündstrom für den Leistungstriac (V2) über eine Triggerdiode (D5) an das Gate des Leistungstriacs (V2) liefert, und daß eine Gleichrichter-Brückenschaltung (D1 bis D4) mit ihren Wechselspannungseingängen in dem Stromzweig zwischen dem Zündkondensator (C1) und dem Gate des Leistungstriacs (V2) liegt und der Stromzweig zwischen den Gleichspannungsausgängen der Brückenschaltung (D1 bis D4) durch einen steuerbaren, im Diagonalzweig der Brückenschaltung liegenden Halbleiterschalter (V1) geschlossen ist, dessen Gate ausgehend vom Steuerschalter (2) gesteuert ist, und daß eine Treiberschaltung zwischen dem Gate des Halbleiterschalters (V1) und dem Steuerschalter (2) liegt, die von einer Versorgungsschaltung (3) gespeist ist, und mit dieser, dem Zündkondensator (C1), dem Steuerschalter (2) sowie einem den Leistungstriac (V2) enthaltenden Leistungsschalter (4), nicht aber mit der Gleichrichterbrükke (D1 bis D4) ein gemeinsames Bezugspotential (M) besitzt; und wobei das RC-Glied und die Versorgungsschaltung (3) zwischen dem Phasenleiter (L) des Netzes und dem Bezugspotential (M) liegen.

EP 0 321 798 B1

**2.** Schaltungsanordnung nach Anspruch 1, dadurch gekennzeichnet, daß zur Treiberschaltung zwei komplementäre Transistoren (T1, T2) gehören, von denen der pnp-Transistor (T1) mit seinem Kollektor über einen Widerstand (R3) am Gate des Halbleiterschalters (V1) und über seinen Emitter mit dem Ausgang (U$_V$) der Versorgungsschaltung (2) verbunden ist, und der npn-Transistor (T2) mit seinem Emitter auf Bezugspotential liegt, während sein Kollektor über einen Widerstand (R5) an der Basis des pnp-Transistors (T2) liegt, die ihrerseits über einen Widerstand (R4) am Ausgang (U$_V$) der Versorgungsschaltung (3) angeschlossen ist, und der Ausgang des Steuerschalters (2) über einen Widerstand (R6) der Basis den npn-Transistors (T2) zugeführt ist.

**3.** Schaltung nach einem der vorhergehenden Ansprüche, dadurch gekennzeichnet, daß die Triggerdiode (D5) zwischen dem Zündkondensator (C1) und dem steuerbaren Halbleiterschalter (V1) im Diagonalzweig der Gleichrichterbrücke (D1 bis D4) liegt.

**4.** Schaltung nach einem der Ansprüche 1 oder 2, dadurch gekennzeichnet, daß die Triggerdiode (D5) zwischen dem Zündkondensator (C1) und dem ersten Wechselspannungseingang der Gleichrichterbrücke (D1 bis D4) liegt.

**5.** Schaltungsanordnung nach einem der vorhergehenden Ansprüche, dadurch gekennzeichnet, daß der steuerbare Halbleiterschalter (V1) ein Triac oder ein Transistor ist.

**6.** Schaltungsanordnung nach einem der vorherghenden Ansprüche, dadurch gekennzeichnet, daß der Halbleiterschalter (V1) ein Thyristor ist, dessen Gate über einen Widerstand (R2) und einen parallelen Kondensator (C2) mit seiner Kathode verbunden ist.

**7.** Schaltungsanordnung nach einem der vorhergehenden Ansprüche, dadurch gekennzeichnet, daß der Widerstand (R1) des RC-Gliedes (R1, C1) am Phasenleiter (L) liegt und das Bezugspotential (M) über die Last (6), vorzugsweise über eine oder mehrere Glühlampen, mit dem Nulleiter (N) des Netzes (5) verbunden ist.

**8.** Schaltungsanordnung nach einem der vorhergehenden Ansprüche, dadurch gekennzeichnet, daß die Versorgungsschaltung (3) mit einem Widerstand (R7) am Phasenleiter (L) und mit einer Zenerdiode (D6) auf Bezugspotential (M) liegt, daß beide durch einen Ladekondensator (C3) verbunden sind, und daß zwischen dem Ladekondensator (C3) und der Zenerdiode (D6) die Anode einer Diode (D7) angeschlossen ist, die in Reihe zu einem auf Bezugspotential (M) liegenden Pufferkondensator (C4) geschaltet ist, wobei der Ausgang (U$_V$) der Versorgungsschaltung (3) zwischen der Diode (D7) und dem Pufferkondensator (C4) liegt.

**9.** Schaltungsanordnung nach einem der vorhergehenden Ansprüche, dadurch gekennzeichnet, daß das Gate des im Leistungsschalter (4) enthaltenen Leistungstriacs (V2) über einen Widerstand (R8) auf Bezugspotential (M) liegt und in Reihe zur Schaltstrecke des Leistungstriacs (V2) zum Phasenleiter (L) hin eine Entstördrossel (E) ggf. mit einer Sicherung (F) in Reihe liegt.

**10.** Schaltungsanordnung nach einem der vorhergehenden Ansprüche, dadurch gekennzeichnet, daß zwischen Phasenleiter (L) und Bezugspotential (M) ein Entstörkondensator (C5) und parallel dazu eine mit einem Vorwiderstand (R9) versehene Suppressordiode (D8) geschaltet ist.

**Claims**

**1.** Circuit arrangement for controlling a power triac (V2) which is in series with a power supply network-supplied load (6) and applies voltage thereto as a function of the switch position of a control switch (2), said control switch (2) acting on the gate of the power triac (V2) via a drive circuit (1) such that a residual phase-gating angle remains before each occasion when its switching path is switched through and, for this purpose, an RC element (R1, C1), which has a triggering capacitor (C1), supplies the triggering current for the power triac (V2) to the gate of said power triac (V2) via a triggering diode (D5), and such that the AC voltage inputs of a rectifier bridge circuit (D1 to D4) are connected in the current path between the triggering capacitor (C1) and the gate of the power triac (V2) and the current path between the DC voltage outputs of the bridge circuit (D1 to D4) by means of a controllable semiconductor switch (V1) which is connected in the diagonal arm of the bridge circuit and whose gate is initially controlled by the control switch (2), and such that a driver circuit is connected between the gate of the semiconductor switch (V1) and the control switch (2), is supplied from a supply circuit (3) and has a common reference potential (M) with this supply circuit (3), the triggering capacitor (C1), the control switch (2) and with a power circuit breaker (4) which contains the power triac (V2), but not with the rectifier bridge (D1 to D4), and the RC element and the supply circuit (3) being connected between the live conductor (L) of the power supply network and the reference potential (M).

2. Circuit arrangement according to Claim 1, characterized in that the driver circuit includes two complementary transistors (T1, T2) of which the collector of the pnp-transistor (T1) is connected via a resistor (R3) at [sic] the gate of the semiconductor switch (V1) and its emitter is connected to the output ($U_V$) of the supply circuit (2), and the emitter of the npn-transistor (T2) is connected to the reference potential while its collector is connected via a resistor (R5) to the base of the pnp-transistor (T2), which base, for its part, is connected via a resistor (R4) to the output ($U_V$) of the supply circuit (3), and the output of the control switch (2) is supplied via a resistor (R6) to the base of the npn-transistor (T2).

3. Circuit according to one of the preceding claims, characterized in that the triggering diode (D5) is connected in the diagonal arm of the rectifier bridge (D1 to D4), between the triggering capacitor (C1) and the controllable semiconductor switch (V1).

4. Circuit according to one of Claims 1 or 2, characterized in that the triggering diode (D5) is connected between the triggering capacitor (C1) and the first AC voltage input of the rectifier bridge (D1 to D4).

5. Circuit arrangement according to one of the preceding claims, characterized in that the controllable semiconductor switch (V1) is a triac or a transistor.

6. Circuit arrangement according to one of the preceding claims, characterized in that the semiconductor switch (V1) is a thyristor whose gate is connected via a resistor (R2) and a parallel capacitor (C2) to its cathode.

7. Circuit arrangement according to one of the preceding claims, characterized in that the resistor (R1) of the RC element (R1, C1) is connected to the live conductor (L), and the reference potential (M) is connected via the load (6), preferably via one or more incandescent lamps, to the neutral conductor (N) of the power supply network (5).

8. Circuit arrangement according to one of the preceding claims, characterized in that the supply circuit (3) is connected to the live conductor (L) by means of a resistor (R7), and is connected to the reference potential (M) by means of a zener diode (D6), in that both are connected by means of a charging capacitor (C3), and in that the anode of a diode (D7) is connected between the charging capacitor (C3) and the zener diode (D6), which diode is connected in series with a buffer capacitor (C4) which is at the reference potential (M), the output ($U_V$) of the supply circuit (3) being connected between the diode (D7) and the buffer capacitor (C4).

9. Circuit arrangement according to one of the preceding claims, characterized in that the gate of the power triac (V2) which is contained in the power circuit breaker (4) is connected to the reference potential (M) via a resistor (R8), and a suppression inductor (E), possibly with a fuse (F) in series, is connected to the live conductor (L) in series with the switching path of the power triac (V2).

10. Circuit arrangement according to one of the preceding claims, characterized in that a suppression capacitor (C5) is connected between the live conductor (L) and the reference potential (M), and a suppressor diode (D8), which is provided with a bias resistor (R9), is connected in parallel with said suppression capacitor (C5).

**Revendications**

1. Agencement de circuit pour la commande d'un triac de puissance (V2) qui se trouve en série avec une charge alimentée par le réseau et met cette dernière sous tension en fonction de la position de commutation d'un contacteur de commande (2) agissant par un circuit de déclenchement (1) sur la gâchette d'un triac de puissance (V2) de telle manière qu'une partie résiduelle de la tension d'alimentation subsiste avant chaque passage à l'état conducteur du trajet de commutation du triac, un élément RC (R1, C1) avec un condensateur d'amorçage (C1) fournissant à cet effet le courant d'amorçage pour le triac de puissance (V2) par l'intermédiaire d'une diode de déclenchement (D5) à la gâchette du triac de puissance (V2), agencement dans lequel un pont de redresseurs (D1 à D4) est relié par ses entrées de tension alternative dans la branche située entre le condensateur d'amorçage (C1) et la gâchette du triac de puissance (V2) et la branche située entre les sorties de tension continue du pont (D1 à D4) est fermée par un contacteur à semi-conducteur (V1) commandé, qui se trouve dans la branche diagonale du pont et dont la gâchette est commandée à partir du contacteur de commande (2), et entre la gâchette du contacteur à semi-conducteur (V1) et le contacteur de commande (2) se trouve un circuit d'attaque qui est alimenté par un circuit d'alimentation (3) et qui possède un potentiel de référence (M) commun avec ce dernier, le condensateur d'amorçage (C1), le contacteur de commande (2) et un contacteur de puissance (4) contenant le triac de puissance (V2), mais non pas avec le pont de redresseurs (D1 à D4) ; et l'élément RC et le circuit d'alimentation (3) se trouvant entre le conducteur de phase (L) du réseau et le potentiel de référence (M).

2. Agencement de circuit suivant la revendication 1, **caractérisé** par le fait que le circuit d'attaque comprend deux transistors complémentaires (T1, T2), le collecteur du transistor pnp (T1) étant relié par une résistance (R3) à la gâchette du contacteur à semi-conducteur (V1) et son émetteur étant relié à la sortie (U$_V$) du circuit d'alimentation (3), et l'émetteur du transistor npn (T2) se trouvant au potentiel de référence, tandis que son collecteur est relié par une résistance (R5) à la base du transistor pnp (T2), laquelle est à son tour reliée par une résistance (R4) à la sortie (U$_V$) du circuit d'alimentation (3), et la sortie du contacteur de commande (5) étant reliée par une résistance (R6) à la base du transistor npn (T2).

3. Agencement de circuit suivant l'une des revendications précédentes, **caractérisé** par le fait que la diode de déclenchement (D5) est située entre le condensateur d'amorçage (C1) et le contacteur à semi-conducteur commandé (V1) dans la branche diagonale du pont de redresseurs (D1 à D4).

4. Agencement de circuit suivant l'une des revendications 1 ou 2, **caractérisé** par le fait que la diode de déclenchement (D5) est située entre le condensateur d'amorçage (C1) et la première entrée de tension alternative du pont de redresseurs (D1 à D4).

5. Agencement de circuit suivant l'une des revendications précédentes, **caractérisé** par le fait que le contacteur à semi-conducteur commandé (V1) est un triac ou un transistor.

6. Agencement de circuit suivant l'une des revendications précédentes, **caractérisé** par le fait que le contacteur à semi-conducteur commandé (V1) est un thyristor dont la gâchette est reliée par une résistance (R2) et un condensateur parallèle (C2) à sa cathode.

7. Agencement de circuit suivant l'une des revendications précédentes, **caractérisé** par le fait que la résistance (R1) de l'élément RC (R1, C1) est reliée au conducteur de phase (L) et que le potentiel de référence (M) est relié par la charge (6), de préférence une ou plusieurs lampes à incandescence, au conducteur neutre (N) du réseau (5).

8. Agencement de circuit suivant l'une des revendications précédentes, **caractérisé** par le fait que le circuit d'alimentation (3) est relié par une résistance (R7) au contacteur de phase (L) et par une diode Zener (D6) au potentiel de référence (M), que les deux sont reliés par un condensateur de charge (C3), et qu'entre le condensateur de charge (C3) et la diode Zener (D6) est raccordée l'anode d'une diode (D7) qui est montée en série avec un condensateur tampon (C4) se trouvant au potentiel de référence (M), la sortie (U$_V$) du circuit d'alimentation (3) se trouvant entre la diode (D7) et le condensateur tampon (C4).

9. Agencement de circuit suivant l'une des revendications précédentes, **caractérisé** par le fait que la gâchette du triac de puissance (V2) se trouvant dans le contacteur de puissance (4) est reliée par une résistance (R8) au potentiel de référence (M) et qu'une bobine d'antiparasitage (E), le cas échéant en série avec un fusible (F), se trouve en série avec la jonction de commande du triac de puissance (V2) vers le conducteur de phase (L)

**10.** Agencement de circuit suivant l'une des revendications précédentes, **caractérisé** par le fait qu'un condensateur d'antiparasitage ($C_5$) est monté entre le conducteur de phase (L) et le potentiel de référence (M) et qu'une diode de suppression (D8) munie d'une résistance série (R9) est montée en parallèle avec ledit condensateur.